(19) Europäisches Patentamt
European Patent Office
Office européen des brevets

(11) **EP 4 661 418 A1**

(12) **EUROPEAN PATENT APPLICATION**

(43) Date of publication:
**10.12.2025 Bulletin 2025/50**

(21) Application number: **25179571.2**

(22) Date of filing: **28.05.2025**

(51) International Patent Classification (IPC):
**H04N 25/771** (2023.01)   **H04N 25/79** (2023.01)
**H10F 39/00** (2025.01)

(52) Cooperative Patent Classification (CPC):
**H04N 25/771; H04N 25/79; H10F 39/8057;
H10F 39/809; H10F 39/811**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **05.06.2024 JP 2024091219**

(71) Applicant: **CANON KABUSHIKI KAISHA
Tokyo 146-8501 (JP)**

(72) Inventor: **KOBAYASHI, Daisuke
Tokyo, 146-8501 (JP)**

(74) Representative: **Canon Europe Limited
European Intellectual Property Group
4 Roundwood Avenue
Stockley Park
Uxbridge UB11 1AF (GB)**

(54) **PHOTOELECTRIC CONVERSION APPARATUS AND EQUIPMENT**

(57)   There is provided a photoelectric conversion apparatus including a plurality of pixels, in which each of the plurality of pixels includes a photoelectric conversion element, a first amplification unit, and a capacitance element configured to hold an output signal of the first amplification unit, the photoelectric conversion element including a shield section arranged to shield the capacitance element and a second amplification unit configured to amplify an output signal output from the capacitance element.

FIG. 6

EP 4 661 418 A1

**Description**

BACKGROUND OF THE INVENTION

Field of the Invention

The present disclosure relates to a photoelectric conversion apparatus and an equipment.

Description of the Related Art

In a photoelectric conversion apparatus, it is suggested that a so-called global shutter operation is performed to reset photoelectric conversion units in pixels and read out electric charges from the photoelectric conversion units in a plurality of pixels across a plurality of rows and a plurality of columns at the same time. Japanese Patent Laid-Open No. 2022-051548 (Patent Document 1) describes a photoelectric conversion apparatus provided with a global shutter function of a voltage holding type in which electric charge signals are converted into voltages to be held. In the photoelectric conversion apparatus described in Patent Document 1, after electric charge signals generated in the photoelectric conversion units are held in capacitance elements across all pixels at the same time, held voltages are sequentially read out to realize a global shutter. A configuration is adopted in which the respective held voltages are read out to a plurality of memories by a source follower circuit.

SUMMARY OF THE INVENTION

The present invention in its first aspect provides a photoelectric conversion apparatus as specified in claims 1 to 17.

The present invention in its second aspect provides a photoelectric conversion apparatus as specified in claim 18.

The present invention in its second aspect provides an equipment as specified in claim 19.

Further features of the present invention will become apparent from the following description of embodiments with reference to the attached drawings.

BRIEF DESCRIPTION OF THE DRAWINGS

Fig. 1 is a schematic diagram of an entire configuration according to a first embodiment.
Fig. 2 a stacked layer structure according to the first embodiment.
Fig. 3 is a readout circuit diagram according to the first embodiment.
Fig. 4 is a circuit diagram of an electric current source according to the first embodiment.
Fig. 5 is an operational timing chart according to the first embodiment.

Fig. 6 is a cross sectional diagram of a stacked layer chip according to the first embodiment.
Fig. 7 is a planar layout diagram of a signal holding memory according to the first embodiment.
Fig. 8 is another cross sectional diagram of the stacked layer chip according to the first embodiment.
Fig. 9 is another planar layout diagram of the signal holding memory according to the first embodiment.
Fig. 10 is another cross sectional diagram of the stacked layer chip according to the first embodiment.
Fig. 11 is another readout circuit diagram according to the first embodiment.
Figs. 12A to 12C illustrate a configuration of an equipment.
Fig. 13 illustrates the configuration of the equipment.

DESCRIPTION OF THE EMBODIMENTS

In Patent Document 1 described above, considerations on crosstalk from one memory to another memory of a plurality of memories has not been conducted. Thus, there is an issue in terms of an improvement in an accuracy of a signal held in a memory. The present disclosure relates to a new technique with which the accuracy of the signal held in the memory is to be improved.

Modes to be illustrated below are to embody a technical concept of the present disclosure and are not to be limiting aspects of the present disclosure. Sizes and positional relationships of components illustrated in the respective drawings may be exaggerated for the sake of clarity in the description. In the following description, the same components are allocated by the same reference numerals, and the description thereof may be omitted.

Hereinafter, embodiments of the present disclosure will be described in detail based on the drawings. It is noted that in the following description, terms that indicate specific directions or positions (for example, "up", "down", "right", and "left", and other terms that incorporate these terms) are used when necessary. The use of these terms is for a purpose for ease of understanding the embodiments with reference to the drawings, and a technical scope of the present invention is not limited by the meanings of those terms.

In the present specification, a plan view means viewing from a direction perpendicular to a light incident surface of a semiconductor layer. In addition, a crosssectional view refers to a surface perpendicular to the light incidence surface of the semiconductor layer. It is noted that in a case where the light incident surface of the semiconductor layer is a rough surface when viewed microscopically, the plan view is defined while the light incident surface of the semiconductor layer when viewed macroscopically is set as a reference.

In the present specification, in a case where a term "impurity concentration" is simply used, it means a net impurity concentration obtained by subtracting an amount compensated by impurities of an opposite conductivity type. In other words, the "impurity concentration" refers to a NET doping concentration. A region with a P type doped impurity concentration higher than an N type doped impurity concentration is a P type semiconductor region. On the other hand, a region with the N type doped impurity concentration higher than the P type doped impurity concentration is an N type semiconductor region.

In addition, in the following embodiments, connection between mutual elements in a circuit may be described. In this case, even when another element is present between the elements of interest, the elements of interest are treated as being mutually connected unless otherwise specified. For example, it is assumed that an element A is connected to one node of a capacitance element C having a plurality of nodes, and an element B is connected to the other node. In such a case too, the element A and the element B are treated as being connected unless otherwise specified.

In each of the embodiments to be described below, as an example of a photoelectric conversion apparatus, an image sensing apparatus will be mainly described. It is noted however that each of the embodiments is not limited to the image sensing apparatus and can be applied to other examples of the photoelectric conversion apparatus. For example, the other examples include a range finding apparatus (apparatus for range finding or the like using focus detection or time of flight (TOF)), a light metering apparatus (apparatus for measurement of a quantity of incident light or the like), and the like. Each of the embodiments of the present invention described below can be implemented solely or as a combination of a plurality of the embodiments or features thereof where necessary or where the combination of elements or features from individual embodiments in a single embodiment is beneficial.

First Embodiment

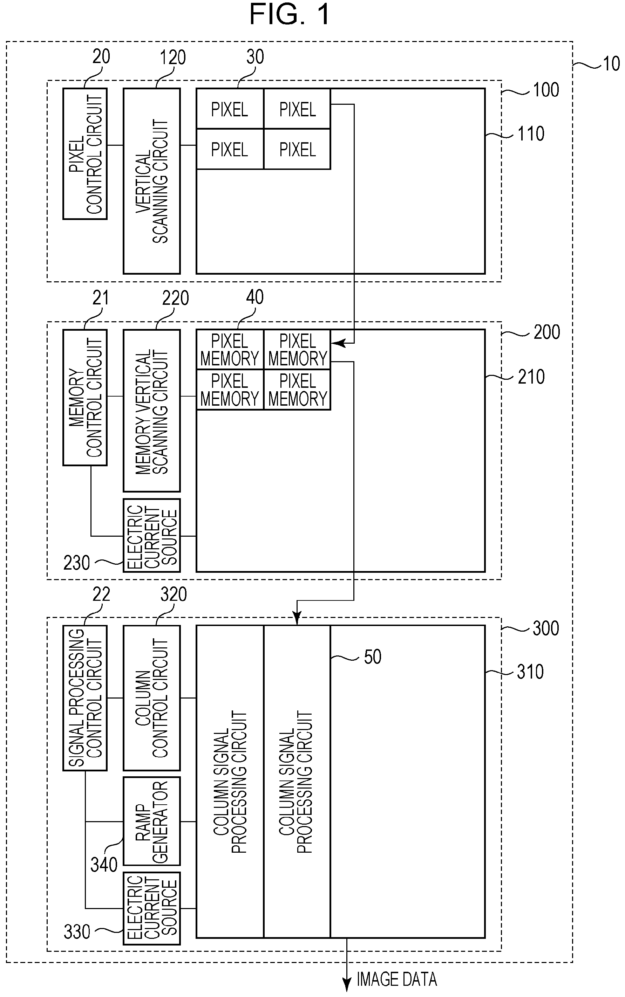

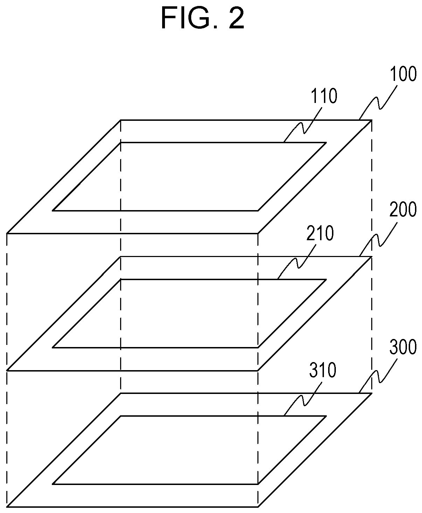

The embodiments of the present disclosure will be described with reference to Fig. 1 to Fig. 11. Fig. 1 is a schematic diagram illustrating a mode of a photoelectric conversion apparatus related to the present disclosure. A photoelectric conversion apparatus 10 adopts a stacked layer structure in which a pixel chip 100 (first member), a memory chip 200 (second member), and a signal processing chip 300 (third member) are stacked as illustrated in Fig. 2. It is noted that more members (chips) may be further stacked. Each of the first member, the second member, and the third member includes a substrate and a wiring structure. The photoelectric conversion apparatus includes a plurality of metal bonding sections each of which is obtained by bonding a metal member of a top layer (first bonding layer) that is an uppermost wiring layer of this wiring structure of the first member and a metal member of a top layer (second bonding layer) that is an uppermost wiring layer of the wiring structure of the second member. In addition, a bonding surface provided with the plurality of metal bonding sections includes an insulating bonding section obtained by bonding an insulating member of the first bonding layer and an insulating member of the second bonding layer. In addition, the second member and the third member are bonded through a bonding structure similar to that of the first member and the second member. In this manner, since the metal members included in the respective members (respective chips) are mutually bonded, signals can be exchanged between the respective members.

The pixel chip 100 illustrated in Fig. 1 includes a pixel region 110, a vertical scanning circuit 120, and a pixel control circuit 20. The pixel region 110 is a region in which a pixel 30 serving as a unit pixel is arranged in array in row and column directions. The pixel 30 includes a photoelectric conversion element such as a photodiode. It is noted that the photoelectric conversion element may be a photoelectric conversion film. The photoelectric conversion element generates an electric charge signal according to incident light. The pixel 30 outputs a signal voltage according to an amount of this electric charge signal. It is noted that in the pixel region 110, in addition to an effective pixel configured to output a pixel signal according to a quantity of the incident light, an optical black pixel in which the photoelectric conversion element is light-shielded, a dummy pixel from which a signal is not output, and the like may be arranged. In addition, the number of rows and the number of columns of a pixel array to be arranged in the pixel region 110 are not particularly limited. The pixel control circuit 20 is a logic circuit configured to perform timing generation for causing the pixel 30 to operate and configured to output a drive pulse of the pixel 30 to the vertical scanning circuit 120. The vertical scanning circuit 120 includes a driver configured to drive the pixels 30 row by row.

The memory chip 200 includes a memory region 210, a memory vertical scanning circuit 220, an electric current source 230, and a memory control circuit 21. The memory region 210 is a region in which a pixel memory 40 is arranged in array in the row and column directions. The pixel memory 40 has a function of holding the signal voltage output from the pixel 30. It is noted that the pixel 30 and the pixel memory 40 do not need to be arranged in the same number. For example, the pixel memory 40 does not need to be arranged for a dummy pixel from which a signal is not output. In addition, a dummy pixel memory from which a signal is not output may be arranged corresponding to the dummy pixel. The electric current source 230 supplies a reference electric current to the pixel memory 40. The memory control circuit 21 includes a logic circuit configured to perform timing generation for causing the pixel memory 40 to operate and configured to control a circuit arranged around the pixel such as the electric current source 230. A drive pulse output from the memory control circuit 21 is input to the memory vertical scanning circuit 220. The memory vertical scanning circuit 220 includes a driving driver configured to drive the pixel memories 40 row by row.

The signal processing chip 300 includes a signal processing unit 310, a column control circuit 320, a ramp generator 340, an electric current source 330, and a signal processing control circuit 22. In the signal processing unit 310, a column signal processing circuit 50 is arranged in array in the column direction. The column signal processing circuit 50 has a function of performing analog-to-digital (AD) conversion of the signal voltage output from the pixel memory 40 based on a reference voltage generated by the ramp generator 340 and outputs a signal after the conversion as image data to the outside of the signal processing chip 300.

The AD conversion of a ramp type will be described as an example according to the present embodiment, but a method of the AD conversion is not limited to the ramp type. For example, the AD conversion of a sequential comparison type, a cyclic type, a ΔΣ type, or the like can be used. In addition, the column signal processing circuit 50 may have a function of performing digital processing such as noise processing on the image data. The electric current source 330 supplies the reference electric current to the column signal processing circuit 50. The signal processing control circuit 22 includes a logic circuit configured to perform timing generation for causing the column signal processing circuit 50 to operate and function settings of the ramp generator 340 and the electric current source 330. The drive pulse output from the signal processing control circuit 22 is input to the column control circuit 320. The column control circuit 320 includes a driving driver configured to output a drive pulse to the column signal processing circuit 50.

The pixel chip 100, the memory chip 200, and the signal processing chip 300 described above are stacked as illustrated in Fig. 2 to constitute the photoelectric conversion apparatus 10.

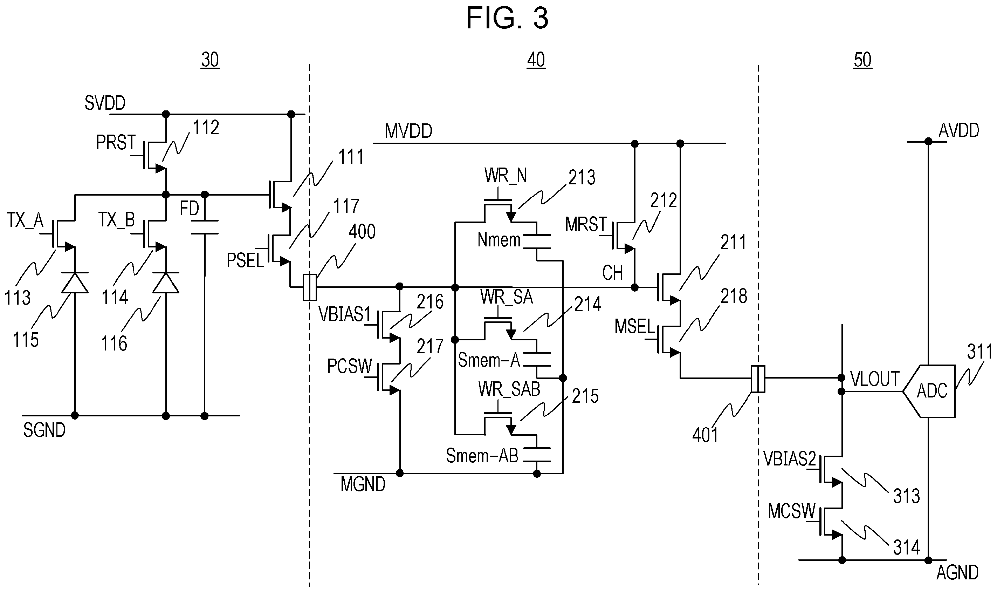

The photoelectric conversion apparatus according to the present embodiment is a photoelectric conversion apparatus configured to perform a global shutter operation of a so-called voltage domain type. Readout of the pixels 30 in the photoelectric conversion apparatus according to the present embodiment will be described with reference to Fig. 3 to Fig. 5.

Fig. 3 is a configuration example of a readout circuit. The pixel 30 includes a photoelectric conversion element (PD) 115, a PD 116, a pixel transfer transistor 113, a pixel transfer transistor 114, and a pixel reset transistor 112. The pixel 30 further includes a pixel amplification transistor 111 (first amplification unit), a pixel selection transistor 117, and a floating diffusion capacitance unit (FD capacitance unit). The FD capacitance unit is an input node of the pixel amplification transistor 111 serving as the first amplification unit. The pixel amplification transistor 111 outputs a signal obtained by amplifying a signal level at this input node. It is noted that the "amplification" in the present specification includes a case where a gain is greater than or equal to 1 time and a case where the gain is less than 1 time. The pixel amplification transistor 111 operates as a source follower circuit. Typically, an amplification factor of the pixel amplification transistor 111 is in a range from 0.8 times to 1 time.

In the photoelectric conversion apparatus according to the present embodiment, the PD 115 and the PD 116 are included in a single pixel. The photoelectric conversion apparatus according to the present embodiment is a photoelectric conversion apparatus of so-called image plane phase difference detection in which signals of the PD 115 and the PD 116 are used for phase difference detection. An anode terminal of the PD 115 is connected to a reference power source SGND, and a cathode terminal is connected to a source of the pixel transfer transistor 113. An anode terminal of the PD 116 is connected to the reference power source SGND, and a cathode terminal is connected to a source of the pixel transfer transistor 114. Each of a drain of the pixel transfer transistor 113 and a drain of the pixel transfer transistor 114 is connected to a gate of the pixel amplification transistor 111 and a source of the pixel reset transistor 112. An FD capacitance is connected to the gate of the pixel amplification transistor 111 while the reference power source SGND is used as a reference and can hold electric charge signals generated by the PD 115 and the PD 116. A drain of the pixel reset transistor 112 and a drain of the pixel amplification transistor 111 are connected to a reference power source SVDD. A source of the pixel amplification transistor 111 is connected to a drain of the pixel selection transistor 117.

Next, a configuration example of the pixel memory 40 will be described. The pixel memory 40 includes a signal holding memory Nmem (second capacitance element), a signal holding memory Smem-A (capacitance element, first capacitance element), and a signal holding memory Smem-AB (third capacitance element). Hereinafter, the plurality of signal holding memories may be collectively referred to as a signal holding memory mem. The signal holding memory Nmem includes a memory write transistor 213, the signal holding memory Smem-A includes a memory write transistor 214, and the signal holding memory Smem-AB includes a memory write transistor 215. The pixel memory 40 is constituted by further including a memory reset transistor 212, a memory amplification transistor 211, an electric current source transistor 216, a switch transistor 217, and a memory selection transistor 218.

A source of the pixel selection transistor 117 of the pixel 30 is connected to a drain of the electric current source transistor 216 of the pixel memory 40 via a bonding section 400. A source of the electric current source transistor 216 is connected to a drain of the switch transistor 217. At this time, control is performed such that VBIAS 1 is supplied to a gate of the electric current source transistor 216 from the electric current source 230, and an electric current based on VBIAS 1 flows. A configuration of the electric current source 230 will be described below.

One terminal of the signal holding memory Nmem is connected to a power source line through which a reference power source MGND is supplied, and the other terminal is connected to a source of the memory write transistor 213. A drain of the memory write transistor 213 is connected to a gate of the memory amplification transistor 211 (second amplification unit). Similarly, one terminal of the signal holding memory Smem-A is connected to the power source line through which the reference power source MGND is supplied, and the other terminal is connected to a source of the memory write transistor 214. A drain of the memory write transistor 214 is connected to the gate of the memory amplification transistor 211. One terminal of the signal holding memory Smem-AB is connected to the power source line through which the reference power source MGND is supplied, and the other terminal is connected to a source of the memory write transistor 215. A drain of the memory write transistor 215 is connected to the gate of the memory amplification transistor 211. At this time, it is sufficient when the signal holding memory serves as an element having a function of holding a signal. For example, a dynamic random access memory (DRAM), a metal-insulator-metal (MIM) capacitance structure formed in the wiring structure, a metal-insulator-semiconductor (MIS) capacitance structure formed using polysilicon and a diffusion layer on Si, or the like is included as the example. The memory amplification transistor 211 operates as a source follower circuit. Typically, an amplification factor of the memory amplification transistor 211 is in a range from 0.8 times to 1 time.

Next, a configuration example of the column signal processing circuit 50 will be described. The column signal processing circuit 50 is constituted by including an ADC 311, an electric current source transistor 313, and a switch transistor 314.

A source of the electric current source transistor 313 is connected to a drain of the switch transistor 314, and a source of the switch transistor 314 is connected to a power source line through which a reference power source AGND is supplied. At this time, VBIAS2 is supplied to a gate of the electric current source transistor 313 from the electric current source 330, and an electric current based on VBIAS2 flows through the electric current source transistor 313. A drain of the electric current source transistor 313 is connected to an input of the ADC 311 via a signal line VLOUT, and the ADC 311 is connected to a power source line through which a reference power source AVDD is supplied and the power source line through which the reference power source AGND is supplied.

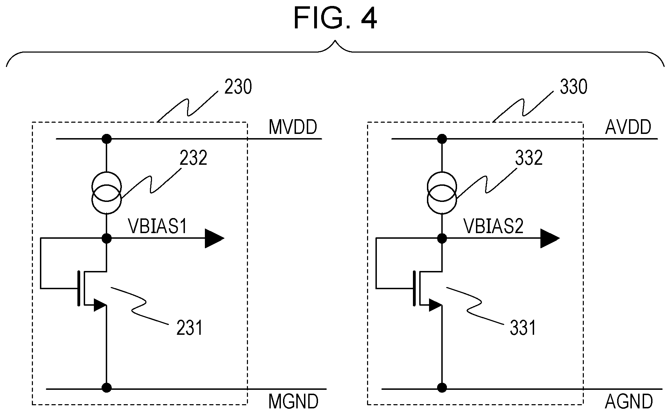

Here, Fig. 4 illustrates configuration examples of the electric current source 230 and the electric current source 330. The electric current source 230 constitutes an electric current mirror together with a reference electric current source 232 and a bias generation transistor 231. The reference electric current source 232 configured to generate a reference electric current is connected between a power source line through which a reference power source MVDD is supplied and a drain of the bias generation transistor 231. A source of the bias generation transistor 231 is connected to the power source line through which the reference power source AGND is supplied. Each of the pixel memories 40 is supplied with VBIAS1 generated by connecting a gate of the bias generation transistor 231 to the drain of the bias generation transistor 231. The electric current source 330 constitutes an electric current mirror together with a reference electric current source 332 and a bias generation transistor 331. The reference electric current source 332 configured to generate a reference electric current is connected between the power source line through which the reference power source MVDD is supplied and a drain of the bias generation transistor 331. A source of the bias generation transistor 331 is connected to the power source line through which the reference power source AGND is supplied. Each of the column signal processing circuits 50 is supplied with VBIAS2 generated by connecting a gate of the bias generation transistor 331 to the drain of the bias generation transistor 331.

The bonding section 400 in the present configuration represents a bonding section where the pixel chip 100 and the memory chip 200 are affixed to each other. A bonding section 401 represents a bonding section where the memory chip 200 and the signal processing chip 300 are affixed to each other. Each of the chips is electrically connected by the bonding section. The bonding section is constituted by, for example, Cu to Cu bonding (CCB), a trough silicon via (TSV), or the like. It is noted that connection relationships of the respective reference power sources are not limited to the configurations described in the present embodiment. For example, the reference power sources SGND and MGND may be common, or the reference power sources MGND and AGND may be common. In addition, the respective control circuits, scanning circuits, and chips in which the electric current sources are arranged are not limited to the configurations described in the present embodiment. For example, the memory control circuit 21 and the electric current source 230 arranged in a second chip may be arranged in a third chip, or the electric current source 330 may be commonly used in the second chip and the third chip. Furthermore, a configuration may be adopted in which the second chip and the third chip are combined to be constituted by a single fourth chip, and a first chip and the fourth chip may be stacked.

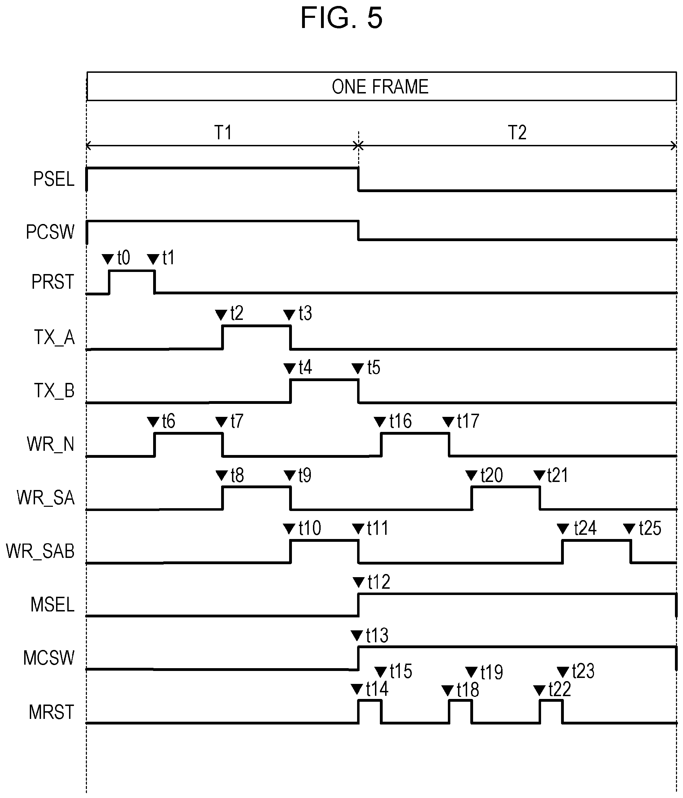

Fig. 5 is an explanatory diagram for describing operation timings of the readout circuit described with reference to Fig. 3. In Fig. 5, a period T1 in which the electric charge signals generated by the photoelectric conversion elements PD 115 and PD 116 are held as voltage signals in the signal holding memory mem and a period T2 in which the voltage signals held in the signal holding memory mem are subjected to AD conversion by the column signal processing circuit 50 will be described.

In Fig. 5, the period T1 in which the electric charge signals generated by the photoelectric conversion elements PD 115 and PD 116 are held as the voltage signals in the signal holding memory and the period T2 in which the voltage signals held in the signal holding memory are subjected to the AD conversion by the column signal processing circuit 50 will be described.

In Fig. 5, in a case where a control signal supplied from each of the control circuits is high, each of the transistors is configured to perform an ON operation (continuity), and in a case where the control signal is low, each of the transistors is configured to perform an OFF operation (non-continuity). Relationships of the respective control signals and the transistors which operate based on the control signals in Fig. 5 will be described also with respect to Fig. 3. In addition, the electric charge signals generated by the photoelectric conversion elements PD 115 and PD 116 and the voltage signals held in the signal holding memory may be collectively referred to as a pixel signal.

During the period T1, control signals PSEL and PCSW turn to high, and the pixel selection transistor 117 and the switch transistor 217 perform the ON operation. Thus, a state is established where outputs from the photoelectric conversion elements PD 115 and PD 116 can be supplied to a node CH via a source follower (SF) circuit constituted by the pixel amplification transistor 111 functioning as an amplification unit and the electric current source transistor 216. First, during a period from a time t0 to a time t1, a control signal PRST turns to high, and the pixel reset transistor 112 performs the ON operation, so that a FD capacitance is reset to an electric potential level based on a power source SVDD. This is set as a first reset period.

After the first reset period is completed, during a period from a time t2 to a time t3, a control signal TX_A turns to high, and the pixel transfer transistor 113 performs the ON operation. Thus, the electric charge signal generated based on the incident light by one (PD 115) of the plurality of photoelectric conversion elements is held in the FD capacitance. Thus, the electric charge signal of the photoelectric conversion element PD 115 is supplied to the node CH via the SF circuit constituted by the pixel amplification transistor 111 and the electric current source transistor 216. This is set as a first transfer period. Similarly, during a period from a time t4 to a time t5, a control signal TX_B turns to high, and the pixel transfer transistor 114 performs the ON operation. Thus, an electric charge signal obtained by adding up the respective electric charge signals generated based on the incident light by one photoelectric conversion element (PD 115) of the plurality of photoelectric conversion elements and the other photoelectric conversion element (PD 116) is held in the FD capacitance. A signal corresponding to this added electric charge signal is supplied to the node CH via the SF circuit constituted by the pixel amplification transistor 111 and the electric current source transistor 216. This is set as a second transfer period. It is noted that the period is not limited this mode, and between the time t3 and the time t4, the control signal PRST may turn to high again and then turn to low. In this case, similarly, during a period from the time t4 to the time t5, since the control signal TX_B turns to high, the electric charge signal generated based on the incident light by the other (PD 116) of the plurality of photoelectric conversion elements is held in the FD capacitance. A signal corresponding to this electric charge signal is supplied to the node CH via the SF circuit constituted by the pixel amplification transistor 111 and the electric current source transistor 216.

Subsequently, control on the memory write transistors 213 to 215 and the voltage signals held in the signal holding memory mem will be described. After the first reset period is ended, during a period from a time t6 to a time t7, an electric potential (hereinafter, which may be referred to as an N level) in a reset state of the FD capacitance is supplied to the node CH via the SF circuit constituted by the pixel amplification transistor 111 and the electric current source transistor 216. This signal at the N level is a signal that mainly contains a noise component. During this period, a control signal WR_N turns to high at the time t6, and the memory write transistors 213 is caused to perform the ON operation to sample the N level in the signal holding memory Nmem to hold at the time t7. A period from a time t8 to a time t9 is the first transfer period, and an electric potential (hereinafter, which may be referred to as an SA level) based on the electric charge signal of the photoelectric conversion element PD 115 on the FD capacitance is supplied to the node CH via the SF circuit constituted by the pixel amplification transistor 111 and the electric current source transistor 216. During this period, a control signal WR_SA turns to high at the time t8, and the memory write transistors 214 is caused to perform the ON operation to sample the SA level in the signal holding memory Smem-A to hold at the time t9. Similarly, a period from a time t10 to a time t11 is the second transfer period, and an electric potential (hereinafter, which may be referred to as an SAB level) based on the electric charge signal of the photoelectric conversion element PD 116 on the FD capacitance is supplied to the node CH via the SF circuit constituted by the pixel amplification transistor 111 and the electric current source transistor 216. During this period, at the time t10, the control signal WR_SAB turns to high, and the memory write transistors 215 is caused to operate the ON operation to sample the SAB level in the signal holding memory Smem-AB to hold at the time t11. Through these operations, the N level, the SA level, and the SAB level are held in the signal holding memory mem as the voltage signals. Herein, a period for sampling and holding the voltage signals in the signal holding memory mem is set as a voltage holding operation period.

A series of these operations from the first reset period to the voltage holding operation period is set as a pixel signal voltage holding operation. By performing the pixel signal voltage holding operation in all the pixels at the same time, a global electronic shutter operation can be realized. The pixel signal voltage holding operation may be performed in all of the pixels 30 and the pixel memories 40 among the plurality of pixels 30 and pixel memories 40, or the pixel signal voltage holding operation may be performed in some of the pixels 30 and the pixel memories 40. For example, the pixel signal voltage holding operation may be sequentially performed on a multiple pixel row basis or a multiple pixel column basis. In addition, the pixel signal voltage holding operation may be performed row by row.

After the pixel signal voltage holding operation, the voltage signals held in the signal holding memory mem are read out to the column signal processing circuit 50. During the period T2 illustrated in Fig. 5, the pixel selection transistor 117 performs the OFF operation. Thus, the pixel 30 and the pixel memory 40 are put into a non-connected state. In addition, since the switch transistor 217 performs the OFF operation, the electric current supplied by the electric current source transistor 216 is interrupted, and the SF circuit constituted by the pixel amplification transistor 111 and the electric current source transistor 216 is put into an inoperative state. Thus, the node CH becomes floating. On the other hand, a time t12, a control signal MSEL turns to high, and the memory selection transistor 218 is caused to perform the ON operation. At a time t13, a control signal MCSW turns to high, and the switch transistor 314 is caused to perform the ON operation. Thus, the node CH is in a state of being connected to the ADC 311 via the SF circuit constituted by the memory amplification transistor 211 which functions as the amplification unit configured to amplify the signal read out from the signal holding memory mem and the electric current source transistor 313.

Herein, the time t12 and the time t13 may be the same timing.

During a period from a time t14 to a time t15, a control signal MRST turns to high, and the memory reset transistor 212 performs the ON operation, so that the node CH is reset to an electric potential level based on a reference power source MVDD. This is set as a second reset period.

After the second reset period, during a period from a time t16 to a time t17, the control signal WR_N turns to high, and the memory write transistors 213 is caused to perform the ON operation, so that the voltage signal held in the signal holding memory Nmem is output to the node CH. The ADC 311 performs AD conversion of the voltage signal which is read out via the SF circuit constituted by the memory amplification transistor 211 and the electric current source transistor 313 and held in the signal holding memory Nmem, that is, a voltage based on the N level. This is set as a first AD conversion period. An electric potential at the node CH is decided according to a capacitance of the node CH, wiring, diffusion capacitances of the memory write transistors 213 to 215, a ratio of a capacitance value of a gate electrode of the memory amplification transistor 211 or the like to a capacitance value of the signal holding memory, and an electric potential difference between each node. For this reason, in the operation illustrated in Fig. 5, a configuration is adopted in which before the voltages held in the respective signal holding memories mem are read out, to reset the node CH to a fixed electric potential, the second reset period is prepared.

After the second reset period occurring from a time t18 to a time t19, during a period from a time t20 to a time t21, the control signal WR_SA turns to high, and the memory write transistors 214 is caused to perform the ON operation. Thus, the voltage signal held in the signal holding memory Smem-A is output to the node CH. The ADC 311 performs AD conversion of the voltage signal which is read out via the SF circuit constituted by the memory amplification transistor 211 and the electric current source transistor 313 and held in the signal holding memory Smem-A, that is, a voltage based on the SA level. This is set as a second AD conversion period.

Furthermore, after the second reset period occurring from a time t22 to a time t23, during a period from a time t24 to a time t25, the control signal WR_SAB turns to high, and the memory write transistors 215 is caused to perform the ON operation. Thus, the voltage signal held in the signal holding memory Smem-AB is output to the node CH. The ADC 311 performs AD conversion of the voltage signal which is read out via the SF circuit constituted by the memory amplification transistor 211 and the electric current source transistor 313 and held in the signal holding memory Smem-AB, that is, a voltage based on the SAB level. This is set as a third AD conversion period.

After the third AD conversion period, the period T2 ends, and the memory selection transistor 218 and the switch transistor 314 perform the OFF operation. Thus, the pixel memory 40 and the column signal processing circuit 50 are put into the non-connected state. In addition, since the switch transistor 314 performs the OFF operation, the electric current supplied by the electric current source transistor 313 is interrupted, and the SF circuit constituted by the memory amplification transistor 211 and the electric current source transistor 313 is put into the inoperative state.

In the operation illustrated in Fig. 5, a reset operation of the photoelectric conversion elements PD 115 and PD 116 is not particularly specified, but for example, a time after the first transfer period and a time after the second transfer period may be set as an accumulation start time. In addition, during the period T2 or at a timing which is not illustrated in the drawing other than the periods T1 and T2, the pixel transfer transistor 113, the pixel transfer transistor 114, and the pixel reset transistor 112 are caused to perform the ON operation. As a result, the photoelectric conversion elements PD 115 and PD 116 may be reset to an electric potential based on the reference power source SVDD. In addition, PD reset transistors which are not illustrated in the drawing may be provided between the PD 115 and the reference power source SVDD and between the PD 116 and the reference power source SVDD to perform the reset operation.

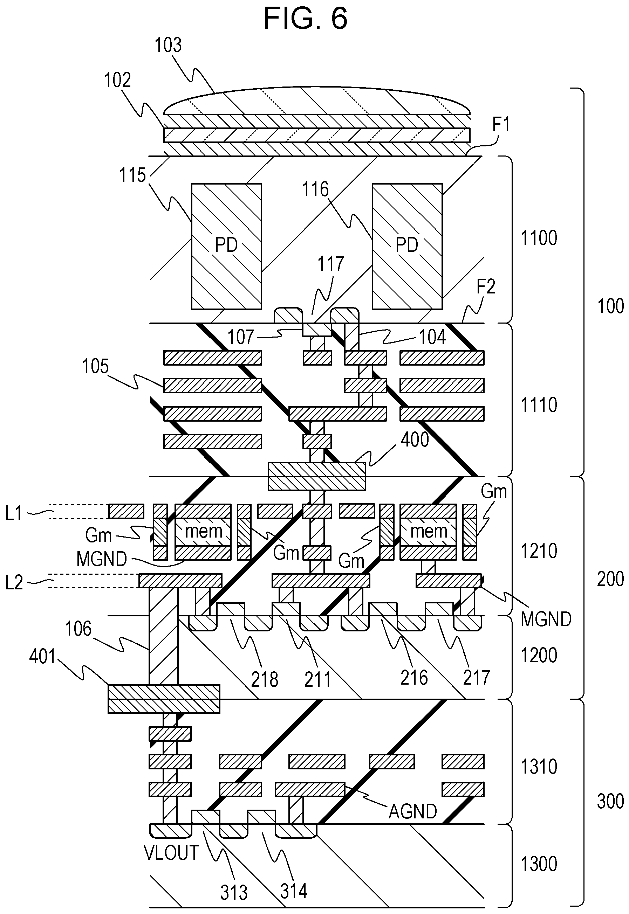

Next, a cross sectional structure of a connection section of the pixel chip 100, the memory chip 200, and the signal processing chip 300 will be described with reference to Fig. 6. It is noted that Fig. 6 illustrates some of the elements and wiring connection of the readout circuit described with reference to Fig. 3. The pixel chip 100 includes a pixel silicon (Si) substrate 1100 (first substrate) and a pixel chip wiring substrate 1110 (first wiring structure). The pixel Si substrate 1100 is a silicon semiconductor substrate and serves as a first semiconductor layer where the photoelectric conversion element and a first readout circuit configured to read out a signal based on the photoelectric conversion of the photoelectric conversion element are formed. It is noted that in a case where instead of a photodiode, a photoelectric conversion film is used as the photoelectric conversion element, this photoelectric conversion film may be provided above the first semiconductor layer. It is noted that the pixel Si substrate 1100 may be formed of a material other than silicon and may be, for example, a compound semiconductor substrate such as a gallium arsenide substrate. Herein, the description will continue where the pixel Si substrate 1100 is a silicon single crystal substrate.

Fig. 6 describes the PD 115, the PD 116, and the pixel selection transistor 117 as examples of the elements included in the pixel Si substrate 1100. A micro lens 103 and a color filter 102 are formed on a light incident surface side of the pixel Si substrate 1100. The color filter 102 has a function of limiting a wavelength band of the incident light. For example, light in a wavelength band corresponding to each of red, green, and blue colors of visible light can be transmitted therethrough. The micro lens 103 has a function of focusing the incident light onto the PD 115 and the PD 116. A first main surface F1 of the pixel silicon (Si) substrate 1100 (first substrate) is a surface where the incident light enters. In addition, a second main surface F2 of the pixel silicon (Si) substrate 1100 (first substrate) is a surface provided with a gate of the transistor. The second main surface F2 is located between the first main surface F1 and the pixel chip wiring substrate 1110 (first wiring structure).

In the pixel chip wiring substrate 1110, a metal wiring 105 which connects each circuit is arranged in multiple layers. Contact vias 104 are provided for connection between the metal wirings 105 in the respective layers and connection between the metal wiring 105 and transistors formed in the pixel Si substrate 1100 and the pixel Si substrate 1100. For example, in the pixel selection transistor 117, the contact via 104 is connected to a source region. A gate electrode 107 is polysilicon forming a gate electrode of the transistor. The pixel chip wiring substrate 1110 is the first wiring structure in which the photoelectric conversion element and each of the first readout circuits are electrically connected.

The memory chip 200 includes a memory Si substrate 1200 (second substrate) and a memory chip wiring structure 1210 (second wiring structure). The memory Si substrate 1200 is a silicon semiconductor substrate and serves as a second semiconductor layer which has a memory and an output circuit configured to output a held voltage of the memory. It is noted that the memory Si substrate 1200 may be formed of a material other than silicon and may be, for example, a compound semiconductor substrate such as a gallium arsenide substrate. Herein, the description will continue where the memory Si substrate 1200 is a silicon single crystal substrate. Fig. 6 illustrates the electric current source transistor 216, the switch transistor 217, the memory amplification transistor 211, and the memory selection transistor 218 as examples of the elements included in the memory Si substrate 1200. Similarly as in the pixel chip wiring substrate 1110, the memory chip wiring structure 1210 is a wiring structure formed by the metal wiring 105, the contact via 104, and the gate electrode 107. The signal holding memory Nmem, the signal holding memory Smem-A, and the signal holding memory Smem-AB of Fig. 3 are formed in the memory chip wiring structure 1210. In Fig. 6, memories are denoted as mem, and two signal holding memories are illustrated.

This is the second wiring structure in which the signal holding memory mem and each of the output circuits are electrically connected.

Herein, it is sufficient when the signal holding memory mem has a function of holding a signal voltage, and as described above, a configuration may be adopted where a capacitance is formed in the memory Si substrate 1200 to hold a signal. This configuration will be described below.

The signal processing chip 300 includes a signal processing Si substrate 1300 (third substrate) and a signal processing chip wiring structure 1310 (third wiring structure). The signal processing Si substrate 1300 is a silicon semiconductor substrate and serves as a third semiconductor layer having a second readout circuit configured to read out a signal according to a held voltage of the memory. Fig. 6 illustrates the electric current source transistor 313 and the switch transistor 314 as examples of the elements included in the signal processing Si substrate 1300.

Similarly as in the pixel chip wiring substrate 1110, the signal processing chip wiring structure 1310 is the third wiring structure formed by the metal wiring 105, the contact via 104, and the gate electrode 107 and being electrically connected to the second readout circuit.

As illustrated in Fig. 6, the pixel chip wiring substrate 1110 of the pixel chip 100 and the memory chip wiring structure 1210 of the memory chip 200 are affixed so as to face each other, and the bonding section 400 (metal bonding section) is formed in an electrically connected part. The bonding section 400 of Fig. 6 is so-called Cu-Cu bonding (which will be denoted as CCB) for affixing a Cu pad (metal member) formed on a lower surface (first layer) of the pixel chip wiring substrate 1110 to a Cu pad (metal member) formed on an upper surface (second layer) of the memory chip wiring structure 1210 for connection. In addition, an insulating bonding section is formed in which an insulating member of the first layer and an insulating member of the second layer are bonded to each other. Furthermore, the memory chip wiring structure 1210 of the memory chip 200 and the signal processing chip wiring structure 1310 of the signal processing chip 300 are connected via the memory Si substrate 1200. A through-silicon via (TSV) 106 is formed in the memory Si substrate 1200 to be connected to a Cu pad prepared on a lower surface of the memory Si substrate 1200. This Cu pad is bonded to a Cu pad formed on an upper surface of the signal processing chip wiring structure 1310 to form the bonding section 401 of CCB.

The pixel selection transistor 117 is connected to the electric current source transistor 216 via the bonding section 400. In addition, the memory selection transistor 218 is connected to the column signal processing circuit 50 and the electric current source transistor 313 via the bonding section 401.

Fig. 6 illustrates a configuration example in which a guard memory Gm having the same structure as the signal holding memory mem is arranged for the signal holding memory mem. As described with reference to Fig. 3, out of two terminals of the signal holding memory mem, one is connected to a memory write transistor which is not illustrated in Fig. 6, and the other is connected to the reference power source MGND. With regard to two terminals of the guard memory Gm, a configuration may be adopted in which the reference power source MVDD or MGND or another reference power source is connected.

In Fig. 6, a plurality of wiring patterns segmented by insulating members are provided in a first layer L1. A portion (first shield portion) of the guard memory Gm is provided in one of the plurality of wiring patterns. In addition, a portion (first capacitance portion) of the signal holding memory mem is provided in a different pattern of the plurality of wiring patterns of the first layer L1. This portion of the guard memory Gm and the portion of the signal holding memory mem are separated by an insulating member.

In Fig. 6, a plurality of wiring patterns segmented by insulating members are provided in a second layer L2. A portion (second shield portion) of the guard memory Gm is provided in one of the plurality of wiring patterns. In addition, a portion (second capacitance portion) of the signal holding memory mem is provided in a different pattern of the plurality of wiring patterns of the second layer L2. This portion of the guard memory Gm and the portion of the signal holding memory mem are separated by an insulating member.

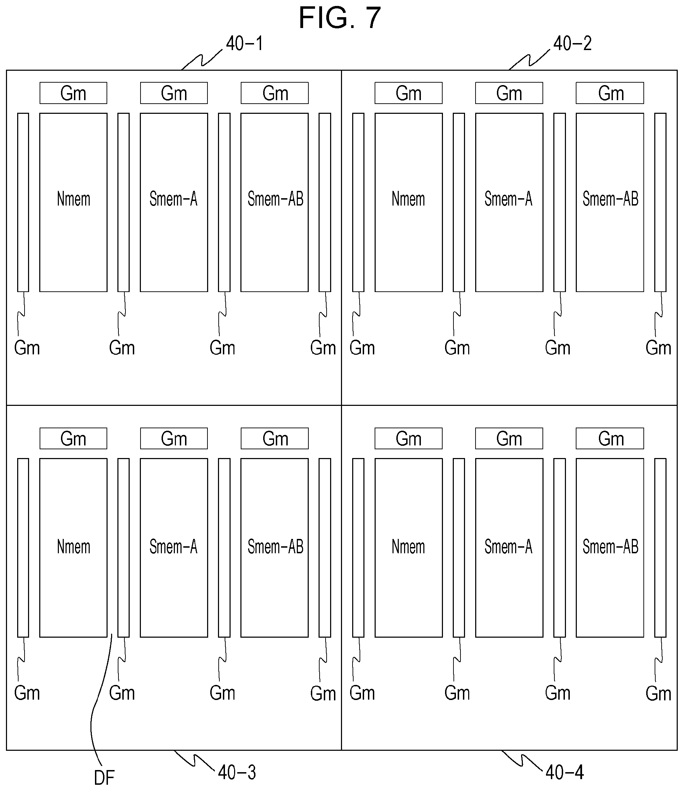

Fig. 7 is a plan view with the pixel memories 40 being arranged in two columns and two rows, illustrating an arrangement of the signal holding memories Nmem, the signal holding memories Smem-A, the signal holding memories Smem-AB, and the guard memories Gm arranged in the memory chip wiring structure 1210. This plan view is a view of the first layer L1 illustrated in Fig. 6 as a plan view relative to the pixel Si substrate 1100. It may be mentioned that Fig. 7 illustrates a plurality of wiring patterns in the first layer L1. The plurality of wiring patterns are electrically separated by an insulating member DF in the first layer L1. It is noted that the plan view with regard to the second layer L2 can be considered to be similar to that of Fig. 7.

As the operational timing has been described with reference to Fig. 3 and Fig. 5, the holding operation and the readout operation of the voltage signals at the N level, the SA level, and the SAB level are performed in the signal holding memory Nmem, the signal holding memory Smem-A, and the signal holding memory Smem-AB at respectively different times. For example, when a parasitic capacitance exists between the signal holding memories mem, the held voltage signal changes by crosstalk between each of the signal holding memories mem. For example, it is assumed that a capacitance value of the signal holding memory Nmem is set as CN, a capacitance value of the signal holding memory Smem-A is set as CA, and a capacitance value of the signal holding memory Smem-AB is set as CAB, and a parasitic capacitance Cp exists between each of the signal holding memories. As described with reference to Fig. 5, in a case where the voltage on the signal holding memory Smem-AB has changed by $\Delta V$ during the period from the time t10 to the time t11, a voltage change represented in Expression (1) occurs in the signal holding memory Nmem, and a voltage change represented in Expression (2) occurs in the signal holding memory Smem-A.

$$\Delta V \times Cp/(Cp + CN) \cdots (1)$$

$$\Delta V \times Cp/(Cp + CA) \cdots (2)$$

Furthermore, during the period T2, when the voltage signal of each of the signal holding memories mem is read out to the column signal processing circuit 50, the voltage on each of the signal holding memories mem changes according to a reset level of the node CH. Thus, crosstalk occurs due to the parasitic capacitance Cp between each of the signal holding memories mem. Similarly, when a parasitic capacitance also exists between the plurality of pixel memories 40, crosstalk also occurs between the pixel memories 40. These may become error factors for the electric charge signals generated by the photoelectric conversion elements PD 115 and PD 116. For example, these may become a linearity error and an offset error of the pixel output signal for the incident light. In addition, due to crosstalk between the signal holding memory Smem-A and the signal holding

**EP 4 661 418 A1**

memory Smem-AB, these may become a phase difference detection error. Furthermore, crosstalk between the pixels results in so-called color mixture between the pixels of different colors to reduce an image quality.

In the configurations of Fig. 6 and Fig. 7, the guard memory Gm is arranged between each of the signal holding memories mem including the adjacent pixel memory 40, and the two terminals are connected to a fixed reference power source, for example. In other words, even when a parasitic capacitance exists between the signal holding memories mem and a voltage change occurs on a certain signal holding memory, propagation of the voltage change to another signal holding memory can be reduced by the guard memory Gm (shield section). In other words, the crosstalk between the signal holding memories mem and between the pixel memories 40 may be reduced. In Fig. 7, a configuration is adopted in which the guard memories Gm are arranged above and on left and right sides of each of the signal holding memory Nmem, the signal holding memory Smem-A, and the signal holding memory Smem-AB in the pixel memory 40. By arranging the guard memories Gm on the left and right sides, the crosstalk between the signal holding memories mem, between the pixel memories 40-1 and 40-2, and between the pixel memories 40-3 and 40-4 can be reduced, and also a symmetry in a longitudinal direction between the signal holding memories can be maintained. In the holding operation of the voltage signal of the signal holding memory mem, noise according to a capacitance value may be generated. Since the capacitance value of the signal holding memory mem varies, for example, a noise variation may occur for each of the pixel memories 40 to reduce the image quality. By arranging the guard memories Gm as in Fig. 7, a shape symmetry may be maintained, and by reducing the variation of the capacitance value, it may be possible to suppress the decrease in the image quality. In addition, by arranging the guard memory Gm above the signal holding memory mem, the crosstalk between the pixel memories 40-1 and 40-3 and between the pixel memories 40-2 and 40-4 can be reduced. On the other hand, since a shorter side direction hardly affects the shape symmetry between the signal holding memories, a configuration is adopted in which the guard memory Gm is arranged only above the signal holding memory, and the metal wiring 105 or the like is arranged in a region equivalent to a location below the signal holding memory although not illustrated in the drawing. It is noted that the power source voltage (reference power source MGND, MVDD, or the like) does not necessarily need to be regularly supplied to this guard memory Gm. The power source voltage (reference power source MGND, MVDD, or the like) is preferably supplied to the guard memory Gm at least during a period in which the signal is written to the signal holding memory mem or a period in which the signal is read out from the signal holding memory mem.

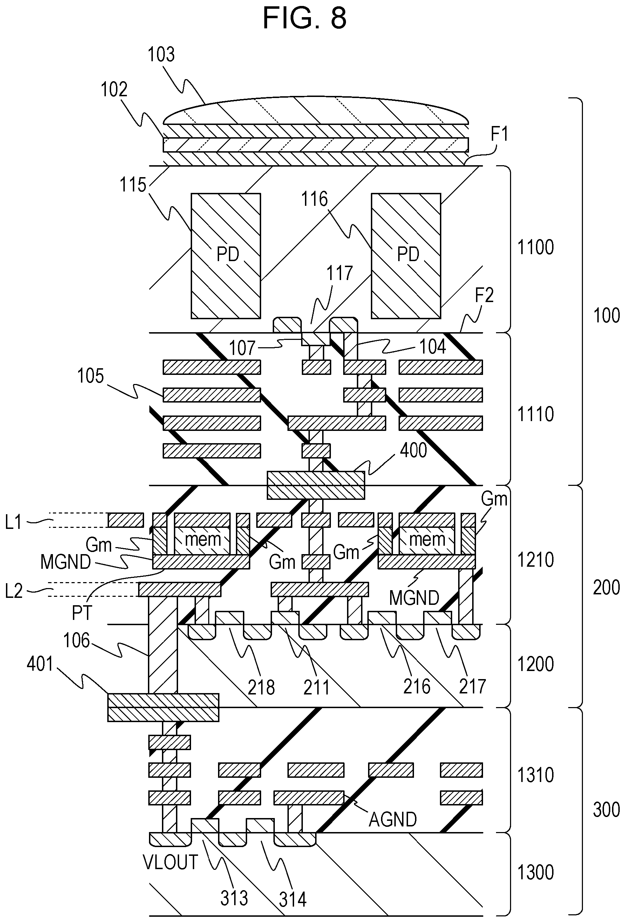

Fig. 8 is another cross sectional view of the photoelectric conversion apparatus of the present embodiment, illustrating an example in which as a connection example of the two terminals of the guard memory Gm, the reference power source MGND through which one terminal is connected to the signal holding memory mem is connected by a common metal wiring, and another fixed electric potential is connected to the other terminal. As described above, the signal voltage connected to the guard memory Gm and a wiring connection relationship are not limited to the configurations described in the present embodiment.

In Fig. 8, a plurality of wiring patterns segmented by insulating members are provided in the first layer L1. A portion (first shield portion) of the guard memory Gm is provided in one of the plurality of wiring patterns. In addition, a portion (first capacitance portion) of the signal holding memory mem is provided in another pattern of the plurality of wiring patterns of the first layer L1. This portion of the guard memory Gm and the portion of the signal holding memory mem are separated by an insulating member.

In Fig. 8, a plurality of wiring patterns segmented by insulating members are provided in the second layer L2. A portion (second shield portion) of the guard memory Gm is provided in one of the plurality of wiring patterns. In addition, a portion (second capacitance portion) of the signal holding memory mem is provided in the pattern. In other words, in the second layer L2 too, the portion of the guard memory Gm and the portion of the signal holding memory mem are provided in this one wiring pattern.

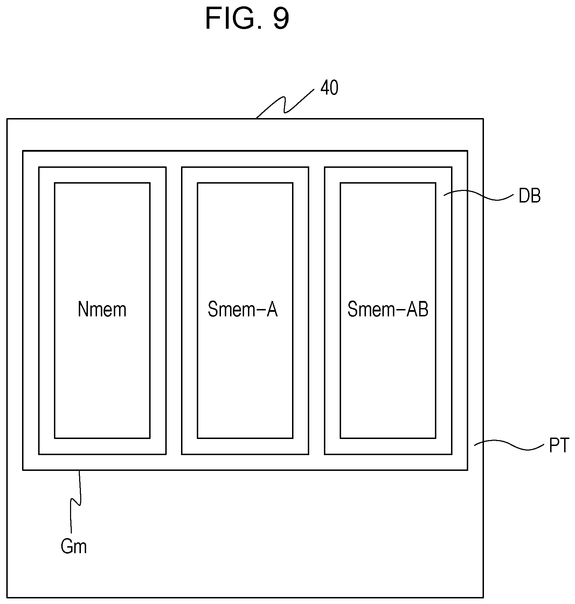

Fig. 9 relates to an arrangement of the signal holding memory mem and the guard memory Gm of the pixel memory 40 and is a plan view different from Fig. 7. The signal holding memory mem is arranged so as to surround one guard memory Gm. Thus, influences from the crosstalk between the signal holding memories mem and in the surrounding of the signal holding memory mem can be reduced. In addition, the arrangement area of the metal wiring 105 through which the voltage of the guard memory Gm is supplied can be reduced, and connection flexibility can be improved.

The plan view of Fig. 9 is a plan view of the first layer L1 and the second layer L2 illustrated in Fig. 8 as a plan view relative to the pixel Si substrate 1100. The plurality of wiring patterns in the first layer L1 are electrically separated by an insulating member DB in the first layer L1. On the other hand, in the second layer L2, the guard memory Gm and the signal holding memory mem are connected to a common wiring pattern PT.

An arrangement relationship, an arrangement distance, shapes, and sizes of the signal holding memory mem and the guard memory Gm are not limited to the configurations described in the present embodiment. For example, the sizes of the signal holding memory mem and the guard memory Gm may be the same or may be different from each other. In addition, the shapes of the signal holding memory mem and the guard memory Gm may be the same or may be different from each other.

Depending on the signal holding memory mem, the distance to the guard memory Gm may vary. In the present embodiment, a feature is that the guard memory Gm is arranged so as to be adjacent to the signal holding memory mem.

It is noted that in the mode of Fig. 8 and Fig. 9, the wiring patterns of the guard memories Gm and the signal holding memories mem are separated from each other in the first layer L1 but provided as the common wiring pattern in the second layer L2. The configuration is not limited to this relationship, and the wiring patterns may be separated from each other in the second layer L2 but provided as the common wiring pattern in the first layer L1.

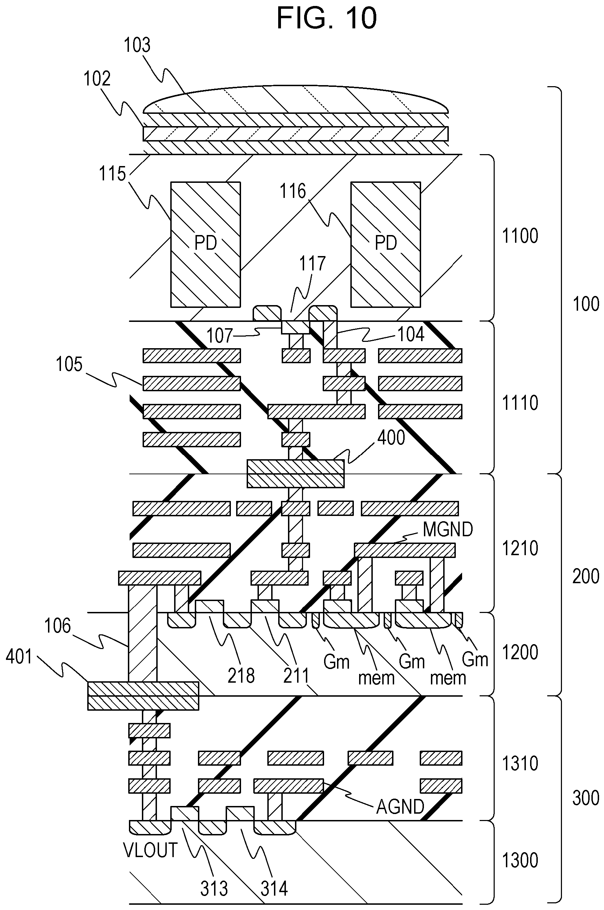

In addition, in the pixel memory 40, the number of all of the guard memories Gm serving as the shield sections to be provided may be higher than the number of all of the signal holding memories mem. When the above-mentioned configuration is adopted, shielding (electric interruption) for the signal holding memory mem can be further strengthened. Fig. 10 is another cross sectional view of the photoelectric conversion apparatus of the present embodiment, illustrating an example in which the signal holding memory mem is arranged on the memory Si substrate 1200. The signal holding memory mem of Fig. 10 is, for example, set as a monolithic capacitance formed by a diffusion layer and a polysilicon electrode. In this example, the guard memory Gm is formed using a diffusion layer and is connected by the contact via 104 to the reference power source MGND, for example, although not illustrated in the drawing. It is noted that the guard memory Gm may adopt a configuration to have the same structure as the signal holding memory mem to be arranged.

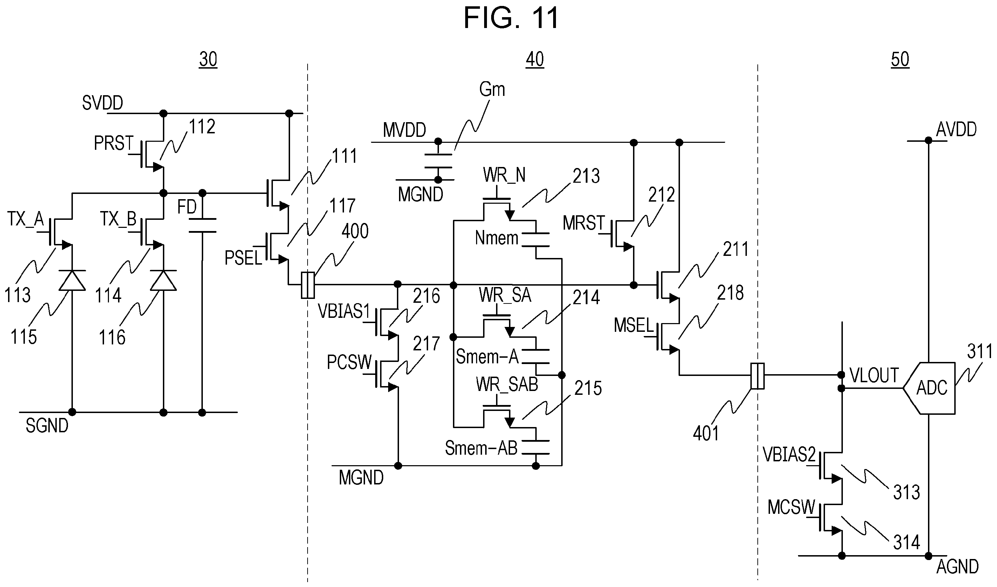

Fig. 11 illustrates an example of the readout circuit of Fig. 3 in which the guard memory Gm is explicitly arranged. A configuration is adopted in which the reference power sources MVDD and MGND are connected to the two terminals of the guard memory Gm. With this configuration, the guard memory Gm can be caused to act as a bypass capacitor of the reference power sources MVDD and MGND connected to the pixel memory 40. In this manner, the guard memory Gm may adopt a configuration to stabilize the reference power sources or other voltage signals.

As described in the above, by arranging another memory to be adjacent to the memory which holds the pixel signal generated by the photoelectric conversion element, the crosstalk between the memories which hold the pixel signal or the crosstalk from the outside can be reduced, and degradation of the image quality can be suppressed.

Second Embodiment

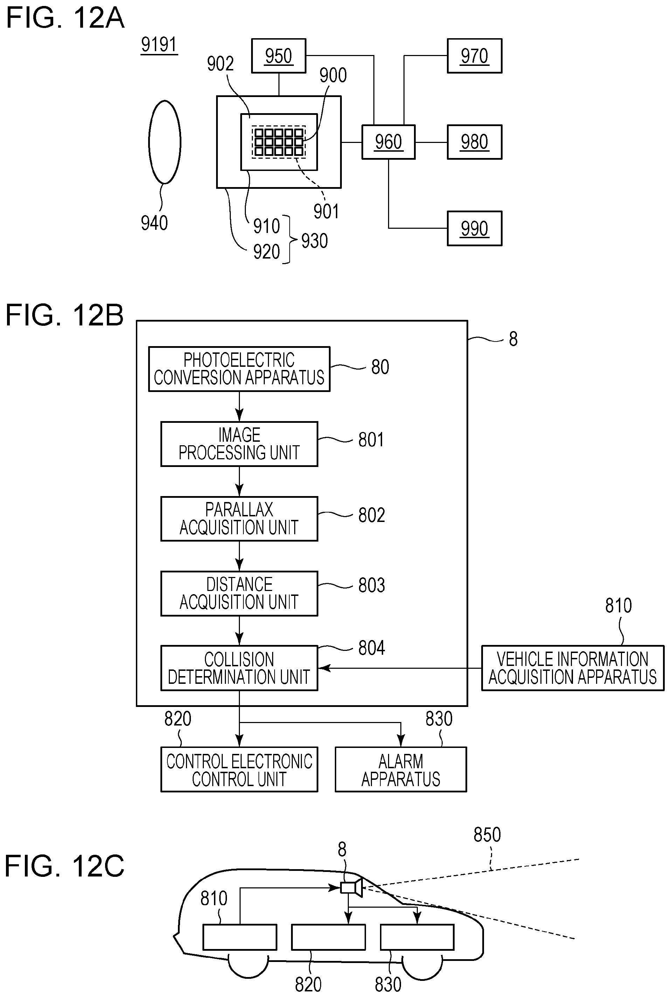

The present embodiment can be applied to any of each of the embodiments described above. Fig. 12A is a schematic diagram for describing an equipment 9191 including a semiconductor apparatus 930 according to the present embodiment. The photoelectric conversion apparatus (image sensing apparatus) according to each of the above-described embodiments can be used as the semiconductor apparatus 930. The equipment 9191 including the semiconductor apparatus 930 will be described in detail. As described above, the semiconductor apparatus 930 can include, in addition to a semiconductor device 910 having a semiconductor layer, a package 920 that accommodates the semiconductor device 910. The package 920 can include a base to which the semiconductor device 910 is fixed and a lid such as glass facing the semiconductor device 910. The package 920 can further include a bonding member such as a bonding wire or a bump that connects a terminal provided in the base and a terminal provided in the semiconductor device 910.

The equipment 9191 may include at least any of an optical apparatus 940, a control apparatus 950, a processing apparatus 960, a display apparatus 970, a storage device 980, and a mechanical apparatus 990. The optical apparatus 940 corresponds to the semiconductor apparatus 930. The optical apparatus 940 is, for example, a lens, a shutter, or a mirror. The control apparatus 950 controls the semiconductor apparatus 930. The control apparatus 950 is, for example, a semiconductor apparatus such as an application specific integrated circuit (ASIC).

The processing apparatus 960 processes a signal output from the semiconductor apparatus 930. The processing apparatus 960 is a semiconductor apparatus such as a central processing unit (CPU) or an ASIC that constitutes an analog front end (AFE) or a digital front end (DFE). The display apparatus 970 is an electroluminescence (EL) display apparatus or a liquid crystal display apparatus configured to display information (image) acquired by the semiconductor apparatus 930. The storage device 980 is a magnetic device or a semiconductor device configured to store the information (image) acquired by the semiconductor apparatus 930. The storage device 980 is a volatile memory such as a static random access memory (SRAM) or a dynamic random access memory (DRAM), or a non-volatile memory such as a flash memory or a hard disk drive.

The mechanical apparatus 990 includes a movable part or a propulsive part such as a motor or an engine. In the equipment 9191, the signal output from the semiconductor apparatus 930 is displayed on the display apparatus 970 or transmitted to the outside by a communication apparatus (not illustrated) included in the equipment 9191. For this reason, the equipment 9191 may preferably further include the storage device 980 or the processing apparatus 960 in addition to a memory circuit or a calculation circuit included in the semiconductor apparatus 930. The mechanical apparatus 990 may be controlled based on the signal output from the semiconductor apparatus 930.

The equipment 9191 is also preferably used as electronic equipment such as an information terminal (for example, a smartphone or a wearable terminal) having an image capturing function or a camera (for example, a lens interchangeable type camera, a compact camera, a video camera, or a monitoring camera). The mechanical apparatus 990 in the camera can drive parts of the optical apparatus 940 for zooming, focusing, and a shutter operation. Alternatively, the mechanical apparatus 990 in the camera can move the semiconductor apparatus 930 for an image stabilization operation.

In addition, the equipment 9191 may be transportation equipment such as a vehicle, a ship, or a flying object. The mechanical apparatus 990 in the transportation equipment may be used as a transportation apparatus. The equipment 9191 serving as the transportation equipment may be preferably used as a component configured to transport the semiconductor apparatus 930 or a component configured to assist and/or automate driving (piloting) by the image capturing function. The processing apparatus 960 configured to assist and/or automate driving (piloting) can perform processing to operate the mechanical apparatus 990 serving as the transportation apparatus based on the information acquired by the semiconductor apparatus 930. Alternatively, the equipment 9191 may be medical equipment such as an endoscope, measuring equipment such as a ranging sensor, analytical equipment such as an electron microscope, office equipment such as a copier, or industrial equipment such as a robot.

According to the above-described embodiments, it becomes possible to attain a satisfactory pixel characteristic. Therefore, a value of the semiconductor apparatus can be increased. For the increase in the value mentioned herein, at least any of an addition of a function, an improvement of a performance, an improvement of a characteristic, an improvement of a reliability, an improvement of a manufacturing yield, a reduction of an environmental impact, a cost reduction, downsizing, and a weight reduction applies.

Therefore, when the semiconductor apparatus 930 according to the present embodiment is used as the equipment 9191, the value of the equipment can also be improved. For example, by mounting the semiconductor apparatus 930 to the transportation equipment, it is possible to attain an excellent performance when an image of an outside of the transportation equipment is captured or an external environment is measured. Thus, when the transportation equipment is to be manufactured and to be on sale, a decision of mounting the semiconductor apparatus according to the present embodiment to the transportation equipment is advantageous in an improvement of the performance of the transportation equipment itself. In particular, the semiconductor apparatus 930 is preferably used as the transportation equipment configured to perform driving assistance and/or automated driving of the transportation equipment by using the information acquired by the above-described semiconductor apparatus.

In addition, a photoelectric conversion system of the present embodiment and a moving object of the present embodiment will be described with reference to Figs. 12A to 12C.

Fig. 12B illustrates an example of a photoelectric conversion system related to an on-vehicle camera. A photoelectric conversion system 8 includes a photoelectric conversion apparatus 80. The photoelectric conversion apparatus 80 is the photoelectric conversion apparatus (image sensing apparatus) described in any of the above-described embodiments. The photoelectric conversion system 8 includes an image processing unit 801 configured to perform image processing on a plurality of pieces of image data acquired by the photoelectric conversion apparatus 80 and a parallax acquisition unit 802 configured to calculate a parallax (phase difference of parallax images) from a plurality of pieces of image data acquired by the photoelectric conversion system 8. The photoelectric conversion system 8 also includes a distance acquisition unit 803 configured to calculate a distance to a target object based on the calculated parallax and a collision determination unit 804 configured to determine whether or not there is a possibility of collision based on the calculated distance. Herein, the parallax acquisition unit 802 and the distance acquisition unit 803 are examples of a distance information acquisition unit configured to acquire distance information of a distance to the target object. That is, the distance information refers to information related to a parallax, a defocus amount, a distance to the target object, or the like. The collision determination unit 804 may determine the possibility of collision by using any of these pieces of distance information. The distance information acquisition unit may be realized by specifically designed hardware or may be realized by a software module. In addition, the distance information acquisition unit may be realized by a field programmable gate array (FPGA), an application specific integrated circuit (ASIC), or the like or may be realized by a combination of these components.

The photoelectric conversion system 8 is connected to a vehicle information acquisition apparatus 810 and can acquire vehicle information such as a vehicle speed, a yaw rate, or a steering angle. The photoelectric conversion system 8 is also connected to a control electronic control unit (ECU) 820 serving as a control apparatus configured to output a control signal for generating a braking force for the vehicle based on a result of the determination in the collision determination unit 804. The photoelectric conversion system 8 is also connected to an alarm apparatus 830 configured to issue an alarm to a driver based on a result of the determination in the collision determination unit 804. For example, in a case where the possibility of collision is high as the determination result of the collision determination unit 804, the control ECU 820 performs vehicle control to avoid a collision or mitigate damage by applying a brake, releasing an accelerator, reducing an engine output, or the like. The alarm apparatus 830 warns a user by sounding an alarm such as a sound, displaying alarm information on a screen such as a car navigation system, applying vibration to a seat belt or a steering wheel, or the like.

In the present embodiment, an image of a surrounding of the vehicle, for example, a front area or a rear area is to be sensed by the photoelectric conversion system 8.

Fig. 12C illustrates the photoelectric conversion system in a case where an image of the front area of the vehicle (image sensing area 850) is to be sensed. The vehicle information acquisition apparatus 810 transmits an instruction to the photoelectric conversion system 8 or the photoelectric conversion apparatus 80. With such a configuration, an accuracy of the range finding can be further improved.

In the above, the example of the control to avoid the collision with other vehicles has been described, but the embodiment can be applied to control for autonomous drive by following other vehicles, control for autonomous drive so as not to stray from its lane, or the like. Furthermore, the photoelectric conversion system can be applied to not only a vehicle such as a car but also a moving object (mobile apparatus) such as, for example, a ship, aircraft, or an industrial robot. Moreover, the embodiment can be applied to not only the moving object but also an equipment that widely uses object recognition such as intelligent transport systems (ITS).

Third Embodiment

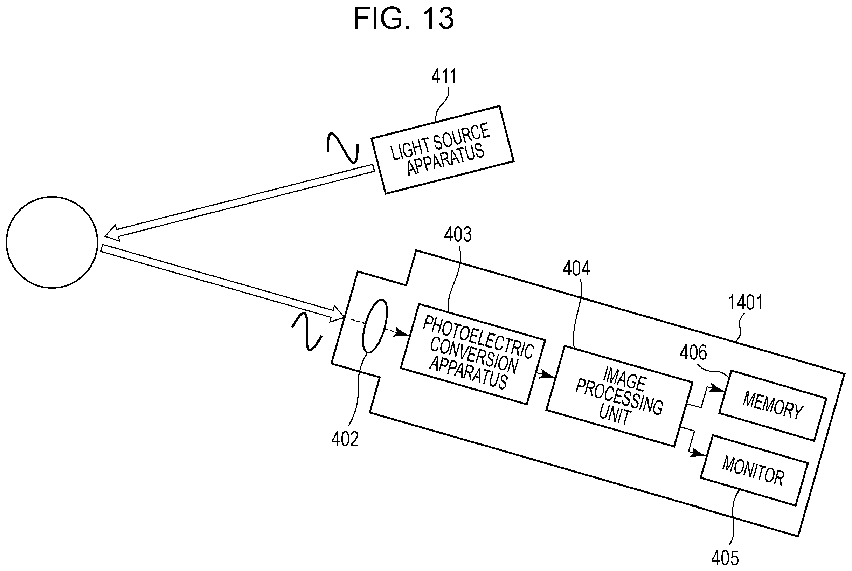

A photoelectric conversion system that is an example of an equipment of the present embodiment will be described with reference to Fig. 13. Fig. 13 is a block diagram illustrating a configuration example of a distance image sensor serving as a photoelectric conversion system of the present embodiment.

As illustrated in Fig. 13, a distance image sensor 1401 is constituted by using an optical system 402, a photoelectric conversion apparatus 403, an image processing circuit 404, a monitor 405, and a memory 406. The photoelectric conversion apparatus according to each of the embodiments described above can be applied as the photoelectric conversion apparatus 403. Light is projected from a light source apparatus 411 towards an object, and the distance image sensor 1401 receives light (modulated light or pulsed light) reflected by a surface of the object, so that a distance image according to a distance to the object can be acquired.

The optical system 402 is constituted by including one or a plurality of lenses and configured to guide image light (incident light) from the object to the photoelectric conversion apparatus 403 to focus on a light receiving surface (sensor unit) of the photoelectric conversion apparatus 403.

The photoelectric conversion apparatus according to each of the embodiments described above is applied as the photoelectric conversion apparatus 403, and a distance signal indicating a distance calculated from a light reception signal output from the photoelectric conversion apparatus 403 is supplied to the image processing circuit 404.

The image processing circuit 404 performs image processing to construct a distance image based on a distance signal supplied from the photoelectric conversion apparatus 403. The distance image (image data) obtained through the image processing is then supplied to the monitor 405 to be displayed or supplied to the memory 406 to be stored (recorded).

In the thus configured distance image sensor 1401, by adopting the above-described photoelectric conversion apparatus, as characteristics of the pixels improve, and a more accurate distance image can be acquired, for example.

Modified Embodiments

The present disclosure is not limited to the above-described embodiments, and various modifications can be made.

For example, the embodiments of the present disclosure also include an example in which a part of the configuration of any of the embodiments is added to another embodiment or an example in which a part of the configuration of any of the embodiments is replaced with a part of the configuration of other embodiments.

In addition, the equipment illustrated in the above-described embodiments represents an example of a photoelectric conversion system to which the photoelectric conversion apparatus may be applied, and the equipment to which the photoelectric conversion apparatus of the present disclosure can be applied and the photoelectric conversion system are not limited to the configurations illustrated in Figs. 12A to 12C and Fig. 13.

It is noted that any of the above-described embodiments merely represent specific examples on how the present disclosure is implemented, and a technical scope of the present disclosure is not to be interpreted as being limited by these. That is, the present disclosure can be implemented in various forms without departing from its technical concept or main characteristics.

The embodiments described above can be modified as appropriate in a scope without departing from the technical concept. It is noted that the content disclosed in the present specification is not limited to described configurations in the present specification but also includes all matters that can be understood from the present specification and the accompanying drawings of the present specification. The content disclosed in the present specification also includes a complement set of concepts described in the present specification. That is, when a phrase "A is larger than B" is stated in the present specification, for example, even when a phrase "A is not larger than B" is omitted, it can be construed that the present specification discloses a notion that "A is not larger than B". This is because in a case where the phrase "A is larger than B" is stated, it is assumed that a case where "A is not larger than B" is taken into consideration.

According to the present disclosure, the crosstalk between the plurality of memories can be reduced, and the signal accuracy can be improved.

While the present invention has been described with reference to embodiments, it is to be understood that the invention is not limited to the disclosed embodiments. The scope of the following claims is to be accorded the broadest interpretation so as to encompass all such modifications and equivalent structures and functions.

**Claims**

1. A photoelectric conversion apparatus (10) comprising:

   a plurality of pixels (30) and a processing circuit (50) configured to process signals read out from the plurality of pixels, wherein each of the plurality of pixels (30) includes a photoelectric conversion element (115, 116), a first amplification unit (111) which includes an input node to which a signal from the photoelectric conversion element (115, 116) is input and which is configured to output a signal obtained by amplifying a level of the signal at the input node, and a capacitance element (Smem-A) configured to hold an output signal of the first amplification unit (111),
   the photoelectric conversion apparatus comprising:

   a shield section (Gm) arranged to shield the capacitance element (Smem-A); and
   a second amplification unit (211) configured to amplify an output signal output from the capacitance element (Smem-A).

2. The photoelectric conversion apparatus (10) according to Claim 1, further comprising:

   a semiconductor substrate (1100) to which the photoelectric conversion element (115, 116) is provided; and
   a wiring layer (1110, 1210), wherein the semiconductor substrate has a first main surface (F1) and a second main surface (F2) located between the wiring layer (1110, 1210) and the first main surface (F1), and the capacitance element (Smem-A) is included in the wiring layer (1110, 1210).

3. The photoelectric conversion apparatus (10) according to Claim 1 or 2, wherein

   the capacitance element (Smem-A) has a first capacitance portion that is a portion provided in a first layer of the wiring layer, and
the shield section (Gm) has a first shield portion that is a portion provided in the first layer.

4. The photoelectric conversion apparatus (10) according to Claim 3, wherein

   the capacitance element (Smem-A) has a second capacitance portion that is a portion provided in a second layer that is a layer different from the first layer of the wiring layer, and
   the shield section (Gm) has a second shield portion that is a portion provided in the second layer.

5. The photoelectric conversion apparatus (10) according to Claim 3 or 4, wherein
   in a plan view relative to the semiconductor substrate, the first capacitance portion is surrounded by the first shield portion.

6. The photoelectric conversion apparatus (10) according to Claim 4 or 5, wherein

   a plurality of wiring patterns respectively segmented by insulating members are provided in the first layer, and
   the first capacitance portion and the first shield portion are included in one wiring pattern of the plurality of wiring patterns.

7. The photoelectric conversion apparatus (10) according to any one of Claims 3 to 5, wherein

   a plurality of wiring patterns respectively segmented by insulating members are provided in the first layer, and
   the first capacitance portion and the first shield portion are included in one wiring pattern of the plurality of wiring patterns.

8. The photoelectric conversion apparatus (10) according to any one of Claims 1 to 7, further comprising:

   a semiconductor substrate (1100) to which the photoelectric conversion element (115, 116) is provided; and
   a wiring layer, wherein the semiconductor substrate (1100) has a first main surface (F1) and a second main surface (F2) located between the wiring layer and the first main surface,
   the capacitance element (Smem-A) has a first capacitance portion provided in the semiconductor substrate,
   the shield section (Gm) has a first shield portion provided in the semiconductor substrate,
   in a plan view relative to the semiconductor substrate, at least a part of the first capacitance portion is sandwiched by the first shield portion, and

at least a part of the first capacitance portion is surrounded by the first shield portion.

9. The photoelectric conversion apparatus (10) according to Claim 8, wherein the capacitance element (Smem-A) includes a metal-insulator-semiconductor capacitance structure.

10. The photoelectric conversion apparatus (10) according to Claim 9, wherein the capacitance element (Smem-A) includes an electrode which contains polysilicon.

11. The photoelectric conversion apparatus (10) according to any one of Claims 1 to 10, wherein

each of the plurality of pixels (30) has a second capacitance element (Nmem) which is provided separately from the capacitance element (Smem-A) and configured to hold the output signal of the first amplification unit (111), and the shield section (Gm) is provided between the capacitance element (Smem-A) and the second capacitance element (Nmem).

12. The photoelectric conversion apparatus (10) according to Claim 11, wherein

each of the plurality of pixels (30) has a third capacitance element (Smem-AB) which is provided separately from the capacitance element (Smem-A) and the second capacitance element (Nmem) and configured to hold the output signal of the first amplification unit (111), the second capacitance element (Nmem) is provided between the capacitance element (Smem-A) and the third capacitance element (Smem-AB), and the shield sections (Gm) are respectively provided between the capacitance element (Smem-A) and the second capacitance element (Nmem) and between the second capacitance element (Nmem) and the third capacitance element (Smem-AB).

13. The photoelectric conversion apparatus (10) according to Claim 11 or 12, wherein

the second capacitance element (Nmem) holds a signal corresponding to a noise component, and the capacitance element (Smem-A) holds a signal corresponding to an electric charge signal generated based on incident light by the photoelectric conversion element (115, 116).

14. The photoelectric conversion apparatus (10) according to Claim 12, wherein

the second capacitance element (Nmem) holds a signal corresponding to a noise component, and the capacitance element (Smem-A) and the third capacitance element (Smem-AB) hold a signal corresponding to an electric charge signal generated based on incident light by the photoelectric conversion element (115, 116).

15. The photoelectric conversion apparatus (10) according to Claim 12 or 14, wherein

each of the plurality of pixels includes a plurality of photoelectric conversion elements (115, 116), the capacitance element (Smem-A) holds a signal corresponding to an electric charge signal generated based on incident light by one photoelectric conversion element (115, 116) of the plurality of photoelectric conversion elements (115, 116), and the third capacitance element (Smem-AB) holds a signal corresponding to an electric charge signal generated based on incident light by at least the other photoelectric conversion element (115, 116) of the plurality of photoelectric conversion elements (115, 116).

16. The photoelectric conversion apparatus (10) according to any one of Claims 12, 14, and 15, wherein the third capacitance element (Smem-AB) holds a signal corresponding to an electric charge signal obtained by adding up the respective electric charge signals generated based on the incident light by the one and the other of the photoelectric conversion elements (115, 116) of the plurality of photoelectric conversion elements (115, 116).

17. The photoelectric conversion apparatus (10) according to Claim 1, wherein

each of the plurality of pixels includes a plurality of capacitance elements (Smem-A) each of which is the capacitance element and a plurality of shield sections (Gm) each of which is the shield section, and the number of all of the plurality of shield sections (Gm) provided in the pixel is higher than the number of all of the capacitance elements (Smem-A) provided in the pixel.

18. A photoelectric conversion apparatus (10) comprising:

a plurality of pixels (30); a processing circuit (50) configured to process signals read out from the plurality of pixels (30); a first member (100) including a first substrate (1100); and

a second member (200) including a second substrate (1200), the first member and the second member being stacked, wherein

each of the plurality of pixels (30) includes a photoelectric conversion element (115, 116), a first amplification unit (111) which includes an input node to which a signal from the photoelectric conversion element (115, 116) is input and which is configured to output a signal obtained by amplifying a level of the signal at the input node, and a capacitance element (Smem-A) configured to hold an output signal of the first amplification unit (111),

the photoelectric conversion apparatus comprising:

a shield section (Gm) arranged to shield the capacitance element (Smem-A), wherein the photoelectric conversion element (115, 116) is arranged in the first member (100), and

the capacitance element (Smem-A) and the shield section (Gm) are arranged in the second member (200).

19. An equipment (9191) comprising the photoelectric conversion apparatus (10) according to any one of Claims 1 to 18, wherein the equipment (9191) further comprises at least any of:

an optical apparatus (940) corresponding to the photoelectric conversion apparatus (10), a control apparatus (950) configured to control the photoelectric conversion apparatus (10), a processing apparatus (960) configured to process a signal output from the photoelectric conversion apparatus (10), a display apparatus (970) configured to display information obtained by the photoelectric conversion apparatus (10), a storage device (980) configured to store the information obtained by the photoelectric conversion apparatus (10), and a mechanical apparatus (990) arranged to operate based on the information obtained by the photoelectric conversion apparatus (10).

# FIG. 1

# FIG. 2

# FIG. 3

EP 4 661 418 A1

# FIG. 4

# FIG. 5

# FIG. 6

# FIG. 7

# FIG. 8

# FIG. 9

# FIG. 10

# FIG. 11

EP 4 661 418 A1

FIG. 12A

FIG. 12B

FIG. 12C

# FIG. 13

411

LIGHT SOURCE
APPARATUS

403

404

1401

402

PHOTOELECTRIC
CONVERSION
APPARATUS

IMAGE
PROCESSING
UNIT

406

MEMORY

MONITOR

405

EP 4 661 418 A1

Europäisches
Patentamt

European
Patent Office

Office européen
des brevets

## EUROPEAN SEARCH REPORT

**Application Number**

EP 25 17 9571

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2008/064435 A1 (CYPRESS SEMICONDUCTOR CORP BEL [BE]; LEPAGE GERALD [BE]) 5 June 2008 (2008-06-05) | 1-8,17 | INV. H04N25/771 H04N25/79 |
| Y | * paragraph [0023] - paragraph [0025]; figure 3A * * paragraph [0030] - paragraph [0037]; figures 4A-4B, 5 * | 9-16,18, 19 | H10F39/00 |
| Y | US 2019/006403 A1 (IKEDA YASUJI [JP]) 3 January 2019 (2019-01-03) * paragraph [0038] - paragraph [0040]; figure 3 * * paragraph [8283]; figure 12A * | 9-16,19 | |
| Y | US 2023/370745 A1 (KOBAYASHI HIROKAZU [JP]) 16 November 2023 (2023-11-16) * paragraph [0051] - paragraph [0062]; figures 4,6 * * paragraph [0030] - paragraph [0035]; figures 3,5 * | 12-16,18 | |
| A | KIM WOO-TAE ET AL: "A High Full Well Capacity CMOS Image Sensor for Space Applications", SENSORS, vol. 19, no. 7, 28 March 2019 (2019-03-28) , page 1505, XP093319522, CH ISSN: 1424-8220, DOI: 10.3390/s19071505 * Section 2.3 Pixel design for MTF; page 6 - page 7; figures 5a-5d * | 1-18 | TECHNICAL FIELDS SEARCHED (IPC) H04N H01L H10F |

-/--

The present search report has been drawn up for all claims

| Place of search | Date of completion of the search | Examiner |
|---|---|---|
| Munich | 1 October 2025 | Dinov, Vassil |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.............................................................................

& : member of the same patent family, corresponding document

EPO FORM 1503 03.82 (P04C01)

Europäisches
Patentamt

European
Patent Office

Office européen
des brevets

# EUROPEAN SEARCH REPORT

**Application Number**

EP 25 17 9571

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CHEN DENIS GUANGYIN ET AL: "A 64 fJ/step 9-bit SAR ADC Array With Forward Error Correction and Mixed-Signal CDS for CMOS Image Sensors", IEEE TRANSACTIONS ON CIRCUITS AND SYSTEMS I: REGULAR PAPERS, IEEE, US, vol. 61, no. 11, 1 November 2014 (2014-11-01), pages 3085-3093, XP011562765, ISSN: 1549-8328, DOI: 10.1109/TCSI.2014.2334852 [retrieved on 2014-10-24] * Section V-B. Parasitic Effects; page 3089 - page 3090; figure 7 * ----- | 1-18 | |

TECHNICAL FIELDS
SEARCHED       (IPC)

The present search report has been drawn up for all claims

| Place of search | Date of completion of the search | Examiner |
|---|---|---|
| Munich | 1 October 2025 | Dinov, Vassil |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 17 9571

This annex lists the patent family members relating to the patent documents cited in the above-mentioned European search report.
The members are as contained in the European Patent Office EDP file on
The European Patent Office is in no way liable for these particulars which are merely given for the purpose of information.

01-10-2025

| Patent document cited in search report | Publication date | Patent family member(s) | Publication date |
|---|---|---|---|
| WO 2008064435 A1 | 05-06-2008 | EP 2095424 A1 | 02-09-2009 |
| | | US 2009230289 A1 | 17-09-2009 |
| | | WO 2008064435 A1 | 05-06-2008 |
| US 2019006403 A1 | 03-01-2019 | JP 6976744 B2 | 08-12-2021 |
| | | JP 2019012905 A | 24-01-2019 |
| | | US 2019006403 A1 | 03-01-2019 |
| US 2023370745 A1 | 16-11-2023 | CN 116868578 A | 10-10-2023 |
| | | JP 7649158 B2 | 19-03-2025 |
| | | JP 2022124338 A | 25-08-2022 |
| | | US 2023370745 A1 | 16-11-2023 |
| | | WO 2022172628 A1 | 18-08-2022 |

EPO FORM P0459

For more details about this annex : see Official Journal of the European Patent Office, No. 12/82

## EP 4 661 418 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022051548 A